(19) Europäisches Patentamt
European Patent Office
Office européen des brevets

(11) **EP 4 136 466 B1**

(12) **FASCICULE DE BREVET EUROPEEN**

(45) Date de publication et mention
de la délivrance du brevet:
**30.10.2024 Bulletin 2024/44**

(21) Numéro de dépôt: **21711569.0**

(22) Date de dépôt: **16.03.2021**

(51) Classification Internationale des Brevets (IPC):
**G01R 27/02** (2006.01)

(52) Classification Coopérative des Brevets (CPC):
**G01R 27/025;** G01R 31/007

(86) Numéro de dépôt international:
**PCT/EP2021/056592**

(87) Numéro de publication internationale:
**WO 2021/209207 (21.10.2021 Gazette 2021/42)**

(54) **PROCEDE DE DETECTION D'UN DEFAUT D'ISOLATION ELECTRIQUE ENTRE UNE SOURCE D'ENERGIE ELECTRIQUE ET UNE MASSE ELECTRIQUE**

VERFAHREN ZUR ERKENNUNG EINES ELEKTRISCHEN ISOLATIONSFEHLERS ZWISCHEN EINER ELEKTRISCHEN STROMQUELLE UND EINER ELEKTRISCHEN MASSE

METHOD FOR DETECTING AN ELECTRICAL INSULATION FAULT BETWEEN AN ELECTRIC POWER SOURCE AND AN ELECTRICAL GROUND

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.04.2020 FR 2003722**

(43) Date de publication de la demande:
**22.02.2023 Bulletin 2023/08**

(73) Titulaire: **Ampere SAS**
**92100 Boulogne-Billancourt (FR)**

(72) Inventeur: **HALALCHI, Houssem**
**75013 Paris (FR)**

(74) Mandataire: **Renault Group**
**Renault s.a.s.**
**1 avenue du Golf**
**FR TCR AVA 055**
**78084 Guyancourt Cedex (FR)**

(56) Documents cités:
**EP-A1- 0 654 673        FR-A1- 3 014 206**
**FR-A1- 3 037 406        JP-A- H0 969 879**
**KR-B1- 100 999 852      US-A1- 2017 106 754**

**Description**

DOMAINE TECHNIQUE DE L'INVENTION

La présente invention concerne de manière générale la sécurité électrique des sources d'énergie électrique telles que les batteries d'accumulateurs.

Elle concerne notamment un dispositif de détection d'un défaut d'isolation électrique entre une source d'énergie électrique et une masse électrique, ce dispositif comportant :

- un générateur de tension pilotable et une résistance électrique de mesure branchés en série entre une borne de la source d'énergie électrique et la masse électrique, et
- un moyen de mesure de l'intensité du courant circulant au travers de la résistance électrique de mesure.

L'invention porte principalement sur un procédé de détection d'un défaut d'isolation électrique, comportant des étapes de :

- pilotage du générateur de tension de manière qu'il établisse entre ses bornes une tension de valeur non nulle, et de
- mesure de la tension aux bornes de la résistance électrique de mesure pour détecter un défaut d'isolation électrique entre la source d'énergie électrique et la masse électrique.

L'invention trouve une application particulièrement avantageuse dans les véhicules automobiles à propulsion électrique.

ETAT DE LA TECHNIQUE

Un véhicule automobile à propulsion électrique comporte d'ordinaire un moteur électrique et une batterie d'accumulateurs qui est spécialement conçue pour alimenter le moteur électrique en courant afin de faire avancer le véhicule.

Une telle batterie d'accumulateurs comporte généralement une pluralité de cellules à basse tension, connectées en série les unes avec les autres de façon que la tension globale aux bornes de la batterie soit suffisamment élevée pour faire avancer le véhicule. La tension aux bornes d'une telle batterie est souvent de l'ordre de 400 V.

Une telle batterie d'accumulateurs est habituellement pilotée par un système de gestion conçu pour en surveiller le bon fonctionnement.

Il est connu, par exemple du document EP0654673, d'équiper un tel système de gestion d'une fonction de détection des défauts d'isolation électrique. Il serait en effet dangereux, en cas de court-circuit entre la batterie d'accumulateurs et la carrosserie d'un véhicule, de laisser la situation perdurer.

Ce document EP0654673 enseigne pour cela de mesurer une résistance d'isolation entre la batterie d'accumulateurs et la carrosserie du véhicule, à l'aide d'un circuit de détection qui comporte un générateur de tension pilotable et une résistance électrique de mesure branchés en série entre une borne de la batterie d'accumulateurs et la carrosserie.

Il est expliqué qu'en générant deux créneaux de tension, il est possible de mesurer deux valeurs de tension aux bornes de la résistance électrique de mesure et d'en déduire la valeur de la résistance d'isolation.

Il est également expliqué que ces mesures de tension doivent être réalisées en régime stationnaire. Ce document propose pour cela une méthode permettant de déterminer quand le régime transitoire s'achève, de façon à pouvoir réaliser les mesures souhaitées au plus tôt.

Ce document enseigne en outre que des erreurs peuvent affecter les mesures réalisées. Pour prévenir ce type d'erreur, ce document propose de calculer la moyenne arithmétique des tensions successivement mesurées et, si cette moyenne varie trop dans le temps, de ne pas exploiter les résultats des mesures.

Un inconvénient de cette solution est qu'en pratique, elle détecte à tort des erreurs de mesure, de sorte que les plages de temps pendant lesquelles les résultats des mesures ne sont pas exploitables sont longues, ce qui peut s'avérer potentiellement dangereux en cas d'apparition d'un court-circuit.

Un autre inconvénient de cette solution est que, lorsqu'un défaut d'isolation électrique est constaté, elle ne permet pas de savoir entre quelles cellules d'accumulateurs de la batterie ce défaut se trouve exactement.

Le document FR3037406A1 décrit une solution présentant également des inconvénients de fiabilité. Par ailleurs, le document US 2017/106754 A1 décrit aussi une approche pour la détection d'un défaut d'isolation.

PRESENTATION DE L'INVENTION

Afin de remédier aux inconvénients précités de l'état de la technique, la présente invention propose un procédé de détection selon la revendication 1.

L'invention concerne également un dispositif de détection d'un défaut d'isolation électrique entre une source d'énergie électrique et une masse électrique, selon la revendication 8.

L'invention concerne aussi un véhicule automobile comportant une source d'énergie électrique, une masse électrique, et un dispositif de détection tel que précité.

DESCRIPTION DETAILLEE DE L'INVENTION

La description qui va suivre en regard des dessins annexés, donnés à titre d'exemples non limitatifs, fera bien comprendre en quoi consiste l'invention et comment elle peut être réalisée.

Sur les dessins annexés :

[Fig. 1] est une vue schématique d'un véhicule automobile conforme à l'invention, comportant une source électrique de tension continue et un circuit de détection d'un défaut d'isolation électrique de cette source ;

[Fig. 2] est une vue schématique du circuit de détection de la figure 1 ;

[Fig. 3] est un graphique illustrant, d'une part, l'état d'un relais de puissance connecté à la source électrique de tension continue de la figure 1, et, d'autre part, les variations d'une tension mesurée par le circuit de détection de la figure 2 ;

[Fig. 4] est une vue de détail de la zone IV de la figure 3 ;

[Fig. 5] est un graphique illustrant, d'une part, l'état d'un chargeur adapté à être connecté à la source électrique de tension continue de la figure 1, et, d'autre part, les variations de la tension mesurée par le circuit de détection de la figure 2, lors de la connexion du chargeur à la source électrique de tension continue ;

[Fig. 6] est un graphique illustrant, d'une part, l'état du chargeur, et, d'autre part, les variations de la tension mesurée par le circuit de détection de la figure 2, lors de la déconnexion du chargeur de la source électrique de tension continue ;

[Fig. 7] est un graphique illustrant un exemple de modélisation d'une variation de la tension mesurée par le circuit de détection de la figure 2 ; et

[Fig. 8] est organigramme illustrant les étapes d'un procédé conforme à l'invention.

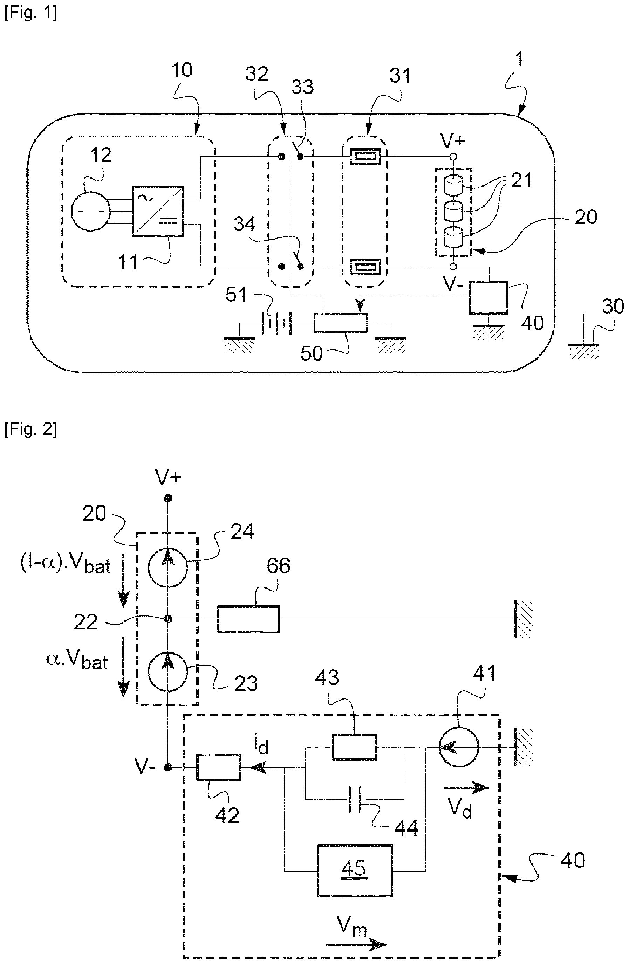

Sur la figure 1, on a représenté un véhicule automobile 1 à propulsion électrique.

Ce véhicule automobile 1 comporte un groupe motopropulseur 10 électrique qui comprend, dans cet exemple, un onduleur 11 et un moteur électrique 12. L'onduleur 11 est classiquement conçu pour convertir une tension continue en une tension alternative.

Pour alimenter l'onduleur 11 en courant électrique, le véhicule automobile 1 comporte une source de tension continue.

Cette source est ici une batterie d'accumulateurs 20 rechargeable.

Une telle batterie d'accumulateurs 20 comporte de manière usuelle un boîtier qui loge une pluralité de cellules d'accumulateurs 21 de tailles réduites, dont le nombre est calculé de telle sorte que le moteur électrique puisse développer un couple et une puissance suffisants pour propulser le véhicule pendant une durée prédéterminée.

Sur la figure 1, pour une raison de clarté, seules trois cellules d'accumulateurs 21 ont été représentées.

Chaque cellule présente habituellement une tension à ses bornes de l'ordre de 3 à 5 V. Ces cellules sont alors connectées en série pour atteindre le niveau de tension requis par l'application. La tension Vbat mesurée aux bornes de la batterie de traction peut ainsi atteindre plus de 400 V lorsque la batterie est chargée.

Les deux bornes de la batterie d'accumulateurs 20, entre lesquelles sont connectées toutes les cellules d'accumulateurs 21, sont appelées bornes $V^-$ et $V^+$.

Le véhicule automobile 1 comporte par ailleurs une carcasse 30, ici formée par le châssis et la carrosserie de ce véhicule qui sont généralement réalisés en matière métallique électriquement conductrice. Cette carcasse 30 forme une masse électrique flottante puisqu'elle n'est pas reliée électriquement en permanence à la terre. Cette carcasse 30 est illustrée sur les figures 1 et 2 par un symbole de masse électrique.

Comme le montre encore la figure 1, le véhicule automobile 1 comporte ici en outre, entre les bornes de la batterie d'accumulateurs 20 et celles de l'onduleur 11, un circuit de protection 31 et un circuit d'accouplement de puissance 32.

Le circuit de protection 31 inclut de façon connue en soi des fusibles configurés pour rompre la connexion lors d'un court-circuit. Il est ici prévu, sur chaque ligne électrique de connexion d'une des bornes de la batterie d'accumulateurs 20 à l'onduleur 11, un fusible. En variante, ce circuit de protection pourrait ne comporter qu'un seul fusible.

Le circuit d'accouplement de puissance 32 comprend au moins un interrupteur permettant de connecter et, en alternance, déconnecter sélectivement les bornes de la batterie d'accumulateurs 20 à l'onduleur 11. Sur la figure 1, ce circuit est représenté comme comportant, sur chaque ligne électrique de connexion d'une des bornes de la batterie d'accumulateurs 20 à l'onduleur 11, un interrupteur 33, 34. En pratique, ce circuit d'accouplement de puissance 32 pourrait ne comporter qu'un seul interrupteur, par exemple connecté entre la borne V$^+$ de la batterie d'accumulateurs 20 et l'onduleur 11.

Le véhicule automobile 1 comporte par ailleurs un système permettant de mesurer l'isolement de la batterie d'accumulateurs 20. Ce système est en pratique formé par un circuit de détection 40 d'un défaut d'isolation électrique entre la batterie d'accumulateurs 20 et la carcasse 30. Ce circuit de détection 40, qui sera décrit en détail dans la suite de cet exposé, est raccordé électriquement à la carcasse 30 et à une unique borne de la batterie d'accumulateurs 20, ici la borne V$^-$.

Le véhicule automobile 1 comporte enfin un calculateur 50 gestionnaire de batterie (« battery management system », ou « BMS » en anglais). Ce calculateur comporte un processeur, une mémoire et une interface d'entrée et de sortie de données.

Grâce à cette interface et à un bus d'échange de données, le calculateur est adapté à recevoir des informations du circuit de détection 40 et il est adapté à piloter les interrupteurs 33, 34 du circuit d'accouplement de puissance 32.

Grâce à sa mémoire, le calculateur mémorise une application informatique, constituée de programmes d'ordinateur comprenant des instructions dont l'exécution par le processeur permet la mise en oeuvre par le calculateur du procédé décrit ci-après.

Ici, ce calculateur 50 est alimenté par l'intermédiaire d'une source de tension continue 51 distincte de la batterie d'accumulateurs 20. Il s'agit en l'espèce de la batterie d'alimentation du réseau de bord du véhicule.

En pratique, lorsqu'il reçoit du circuit de détection 40 une information indiquant qu'un défaut d'isolation électrique a été détecté, le calculateur 50 est programmé pour piloter l'ouverture des deux interrupteurs 33, 34 du circuit d'accouplement de puissance 32.

Par défaut d'isolation, on entend ici la présence anormale d'un contact électrique de faible résistance électrique entre la carcasse 30 et un point de potentiel électrique de la batterie d'accumulateurs 20. Ce point de potentiel électrique peut être formé par l'une des bornes V$^+$, V$^-$ de la batterie, mais pas seulement. Il peut s'agir de toute zone située entre ces deux bornes.

Ici, une résistance est dite faible si elle est inférieure ou égale à un seuil de sécurité prédéfini, par exemple 100k$\Omega$.

Du fait de la fixation sur la carcasse du véhicule de la batterie d'accumulateurs 20 et des charges alimentées en courant par cette batterie, il existe inévitablement une résistance, dit d'isolation, entre la batterie d'accumulateurs 20 et la carcasse 30. En temps normal, cette résistance d'isolation est très supérieure au seuil de sécurité précité.

La figure 2 illustre un unique défaut d'isolation électrique entre un point 22 de la source batterie d'accumulateurs 20 et la carcasse 30. Ce défaut d'isolement se traduit ici par l'apparition d'une résistance d'isolation 66 qui raccorde ce point 22 et la carcasse 30 et qui présente une valeur, notée R$_i$, inférieure au seuil de sécurité précité.

Dans cette situation, un courant de fuite potentiellement dangereux s'écoule au travers de cette résistance d'isolation 66 vers la carcasse 30. Un tel courant de fuite est indésirable et peut mettre en danger un utilisateur du véhicule automobile 1 qui entrerait en contact direct avec la carcasse 30.

Le circuit de détection 40 est alors spécifiquement conçu pour détecter une telle situation. Pour cela, il se base sur une modélisation d'un défaut d'isolation électrique de présentant sous la forme du schéma de la figure 2.

Sur cette figure 2, on notera que la batterie d'accumulateurs 20 a été représentée au moyen deux sources de tension continue 23, 24 connectées en série l'une avec l'autre entre les bornes V$^+$, V$^-$, de part et d'autre du point 22.

On peut alors écrire que ces deux sources de tension continue 23, 24 délivrent respectivement entre leurs bornes des tensions $(1- \alpha).Vbat$ et $\alpha.Vbat$, avec $\alpha$ un nombre réel appartenant à l'intervalle [0 ; 1].

La connaissance de ce coefficient $\alpha$ permettra de connaître précisément la position du défaut dans la batterie d'accumulateurs 20.

Sur cette figure 2, on a également représenté plus en détail un mode de réalisation du circuit de détection 40.

On y observe que ce circuit de détection 40 comporte :

- une source 41 adaptée à appliquer une tension continue notée V$_d$ entre la borne V$^-$ de la batterie d'accumulateurs 20 et la carcasse 30,
- un circuit RC parallèle, comportant une résistance de mesure 43, de valeur notée R$_m$, et un condensateur 44 de capacité notée C$_m$, et
- une résistance de limitation de courant 42, de valeur notée R$_d$.

La source 41, le circuit RC parallèle et la résistance de limitation de courant 42 sont branchés en série entre la borne V$^-$ de la batterie d'accumulateurs et la carcasse 30.

La source 41 est commandée par le calculateur 50 pour appliquer une tension V$_d$ qui conduit à l'apparition d'un courant électrique I$_d$ qui traverse la résistance de limitation de courant 42.

La valeur R$_d$ de cette résistance 52 est alors choisie suffisamment faible pour faciliter la mesure du courant électrique I$_d$ tout en étant suffisamment élevée pour ne pas dégrader l'isolation électrique de la batterie d'accumulateurs 20. Elle est ici au moins 5 fois supérieure au seuil de sécurité prédéfini (dont on rappelle qu'il est ici de 100k$\Omega$).

La valeur $R_m$ de la résistance de mesure 43 est avantageusement choisie de sorte que le rapport $R_d/R_m$ soit compris entre 1 et 100 pour maintenir au sein d'une gamme étroite les valeurs de courant $I_d$.

Le circuit de détection 40 est ici adapté à mesurer la tension $V_m$ aux bornes du circuit RC parallèle, au moyen par exemple d'un convertisseur analogique/numérique à base d'amplificateurs différentiels, connecté électriquement en parallèle avec ce circuit RC parallèle. La mesure de cette tension $V_m$ revient à mesurer le courant $I_d$.

Pour détecter un défaut d'isolation électrique de la batterie d'accumulateurs 20, le calculateur 50 met en oeuvre un procédé de détection en boucles, à pas de temps réguliers. A chaque boucle, le calculateur procède en deux phases pouvant être mises en oeuvre successivement (dans n'importe quel sens) ou concomitamment.

De façon préférentielle, il met en oeuvre une première phase du procédé qui consiste à détecter un possible défaut d'isolation. Dans le cas où un tel défaut a été détecté, il met en oeuvre une seconde phase, qui fait plus précisément l'objet de la présente invention, et qui consiste à vérifier que les conditions pour détecter un tel défaut étaient bien réunies et que la détection ainsi réalisée était fiable.

Pour mettre en oeuvre la première phase, le calculateur 50 commande la source 41 de telle sorte qu'elle applique pendant une première période $T_1$ une première tension de valeur notée $V_{d1}$, puisqu'elle applique pendant une seconde période $T_2$ une seconde tension de valeur notée $V_{d2}$.

Ces deux périodes sont successives. Elles peuvent se suivre immédiatement ou être disjointes, l'intervalle de temps s'écoulant entre ces deux périodes devant être réduit.

Ici, chaque période a une durée de l'ordre de la seconde.

Les valeurs $V_{d1}$, $V_{d2}$ de tension appliquée sont ici différentes, mais elles sont de même polarité.

A chacune de ces valeurs correspond une valeur $I_{d1}$, $I_{d2}$ de courant $I_d$, et une valeur $V_{m1}$, $V_{m2}$ de tension $V_m$.

Du fait de la présence de condensateurs, lorsqu'une tension est appliquée, le courant $I_d$ et la tension $V_m$ mesurée présentent d'abord une phase dite de régime transitoire, au cours de laquelle leurs valeurs varient de façon importante, suivie d'une phase dite de régime permanent, au cours de laquelle leurs valeurs se stabilisent autour d'une constante. Il est préférable d'attendre que le régime permanent soit établi pour procéder à la mesure des valeurs $V_{m1}$, $V_{m2}$ de tension $V_m$. En pratique, la mesure de ces valeurs intervient à la fin des périodes $T_1$, $T_2$.

Le calculateur 50 procède ensuite au calcul de la valeur $R_i$ de la résistance d'isolation 66, au moyen de la formule suivante :

[Math. 1]

$$R_i = R_m \cdot \frac{V_{d2} - V_{d1}}{V_{m2} - V_{m1}} - (R_d + R_m)$$

La valeur du coefficient $\alpha$ est quant à elle calculée par le calculateur 50 au moyen de la formule suivante :

[Math. 2]

$$\alpha = \frac{V_{m1} \cdot V_{d2} - V_{m2} \cdot V_{d1}}{V_{bat} \cdot (V_{m2} - V_{m1})}$$

Dans ces deux équations, on suppose que la tension $V_{bat}$ aux bornes de la batterie d'accumulateurs 20 est restée constante d'une période à l'autre.

En variante, si on souhaite tenir compte d'une variation possible de cette tension depuis une valeur notée $V_{bat1}$ à une autre valeur notée $V_{bat2}$, on peut utiliser les formules suivantes :

[Math. 3]

$$R_i = \frac{R_m}{V_{m2} - V_{m1}} \cdot \left[ V_{d2} - V_{d1} + \frac{(V_{bat2} - V_{bat1}) \cdot (V_{m1} \cdot V_{d2} - V_{m2} \cdot V_{d1})}{V_{m2} \cdot V_{bat1} - V_{m1} \cdot V_{bat2}} \right] - (R_d + R_m)$$

[Math. 4]

$$\alpha = \frac{V_{m1} \cdot V_{d2} - V_{m2} \cdot V_{d1}}{V_{bat1} \cdot V_{m2} - V_{m1} \cdot V_{bat2}}$$

En pratique, les valeurs prises par la tension $V_m$ mesurée sont généralement bruitées. Les résultats des deux équations utilisées sont alors filtrés. Préférentiellement, on utilisera un filtre RLS (de l'anglais « Recursive least squares ») afin d'obtenir une approximation stable de la valeur $R_i$ de la résistance d'isolation 66 et du coefficient $\alpha$.

Le calculateur compare alors cette valeur $R_i$ avec le seuil de sécurité prédéfini (qui est ici de 100kΩ).

Tant que cette valeur est supérieure au seuil, aucune action n'est entreprise par le calculateur. En effet, dans cette situation, on estime que la résistance est telle qu'aucun courant de fuite n'est présent.

Dans le cas contraire, une détecte un possible courant de fuite, au niveau d'une cellule d'accumulateurs dont la position peut être déterminée au moyen du coefficient $\alpha$.

Dans ce cas, le calculateur met en oeuvre la seconde phase du procédé pour contrôler que cette détection est fiable.

Il est en effet des situations dans lesquelles le calculateur 50 détectera à tort une fuite de courant. On parlera ci-après de « situation à risque ».

Ces situations à risque interviennent lorsque le signal mesuré par le circuit de détection 40 est perturbé par des composants électroniques connectés à la batterie d'accumulateurs.

La seconde phase va donc permettre de contrôler si l'on se trouve ou non dans l'une de ces situations à risque.

Ces situations à risque interviennent en cas de perte de synchronisation entre la tension $V_d$ et la tension $V_m$ mesurée.

Avant de décrire la façon selon laquelle cette seconde phase est mise en oeuvre en pratique, on va tout d'abord décrire deux exemples non limitatifs de situations à risque, génératrices de mauvaises détections de défaut d'isolation.

Le premier exemple de situation à risque est lié à la commutation du ou des interrupteurs 33, 34 du circuit d'accouplement de puissance 32.

Comme cela a déjà été évoqué, la fermeture du ou des interrupteurs 33, 34 permet de connecter la batterie d'accumulateurs 20 à l'onduleur 11. Elle est par exemple commandée à chaque démarrage du véhicule après un stationnement prolongé. Elle intervient donc régulièrement.

On constate que la fermeture des interrupteurs 33, 34 n'est pas immédiate après que le calculateur 50 a délivré un signal de commutation.

Ainsi, la transition entre les états $E_T$ « ouvert » et « fermé » n'est pas instantanée, mais s'accompagne nécessairement d'un état intermédiaire dit « transitoire », traduisant les phénomènes de charge et de décharge des bobines de commande des interrupteurs 33, 34.

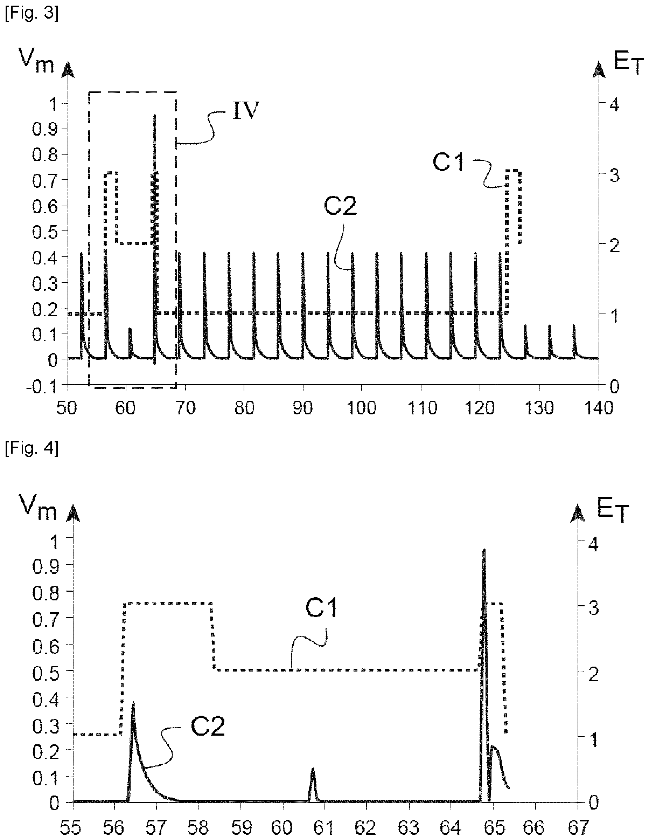

Sur la figure 3, et sur la figure 4 qui est une vue de détail de la figure 3, on a représenté les changements d'états $E_T$ de ces interrupteurs 33, 34 à l'aide de la courbe C1. Cette courbe prend la valeur 1 lorsque les interrupteurs sont à l'état fermé, la valeur 2 à l'état ouvert, et la valeur 3 à l'état transitoire.

La courbe C2 représente les variations de la valeur $V_m$ de la tension mesurée lorsque la source 41 établit périodiquement une même tension à ses bornes.

On observe alors à la fermeture des interrupteurs 33, 34 que lors des états transitoires, la tension $V_m$ est perturbée, ce qui risque de générer une fausse détection d'un courant de fuite.

Le second exemple de situation à risque est lié au chargeur de la batterie de traction 20.

Si le véhicule automobile 1 est du type électrique rechargeable, il est équipé d'un chargeur électrique permettant de recharger la batterie d'accumulateurs 20 sur une prise électrique d'un réseau électrique local (par exemple une prise d'une habitation). Les bornes de ce chargeur sont alors respectivement connectées aux bornes de la batterie d'accumulateurs 20.

Lorsque le chargeur est branché au réseau électrique local, la détection d'un défaut d'isolation électrique n'est plus prise en charge par le calculateur 50 gestionnaire de batterie, mais par un calculateur tiers équipant le chargeur.

Au moment du basculement, on constate la présence d'un temps de latence entre le moment de la connexion physique du chargeur au réseau électrique global et le moment de la réception par le calculateur 50 de la requête lui demandant de cesser de tenter de détecter un défaut d'isolation électrique.

Pendant cet intervalle de temps, on observe que la tension $V_m$ mesurée est perturbée. On observe ce même genre de perturbation après que le chargeur a été physiquement déconnecté du réseau électrique local.

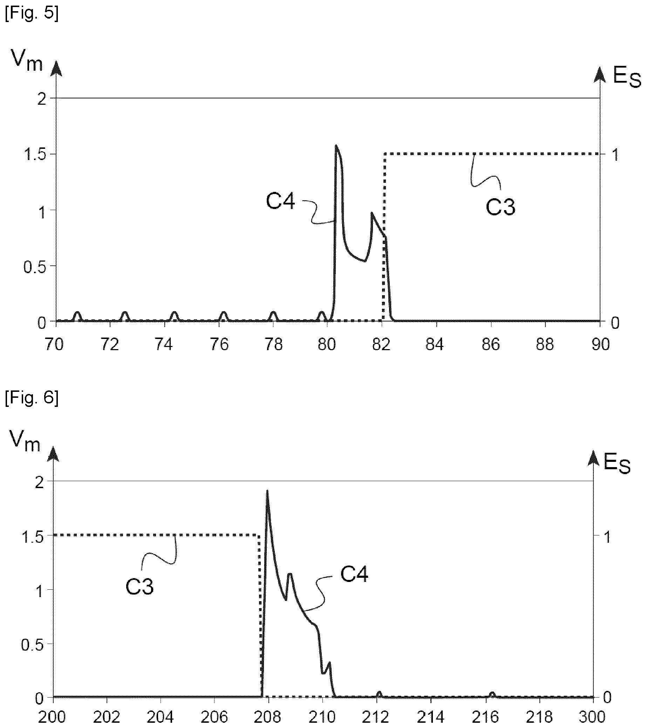

Sur les figures 5 et 6, on a représenté à l'aide de la courbe C3 l'état Es connecté ou déconnecté du chargeur. Cette courbe prend la valeur 1 lorsque le chargeur est connecté au réseau électrique local, et la valeur 0 lorsqu'il en est déconnecté. La courbe C4 représente les variations de la tension $V_m$ mesurée.

On remarque sur ces figures que lorsque le chargeur est à l'état déconnecté, la source 41 établit périodiquement une tension à ses bornes pour réaliser la détection d'un défaut d'isolation électrique. Aucune tension de ce genre n'est en revanche établie par la source 41 lorsque le chargeur est connecté.

On observe alors sur la figure 5 que juste avant que le calculateur 50 ait reçu sa requête lui demandant de cesser sa surveillance, la tension $V_m$ (utilisée pour l'estimation de la valeur $R_i$ de la résistance d'isolation 66) est perturbée, ce qui risque de générer une fausse détection d'un défaut d'isolation électrique.

On observe également sur la figure 6 que juste après que le calculateur 50 a reçu sa requête lui demandant de reprendre sa surveillance, la tension $V_m$ est perturbée, ce qui risque de générer une fausse détection d'un défaut d'isolation électrique.

La présente invention propose de repérer les situations à risque (dans lesquelles un défaut d'isolation électrique risque d'être détecté à tort), à l'aide de critères simples mais efficaces. Elle propose ainsi de repérer ces situations à risque en se basant uniquement sur la forme des variations du signal de la tension $V_m$ mesurée.

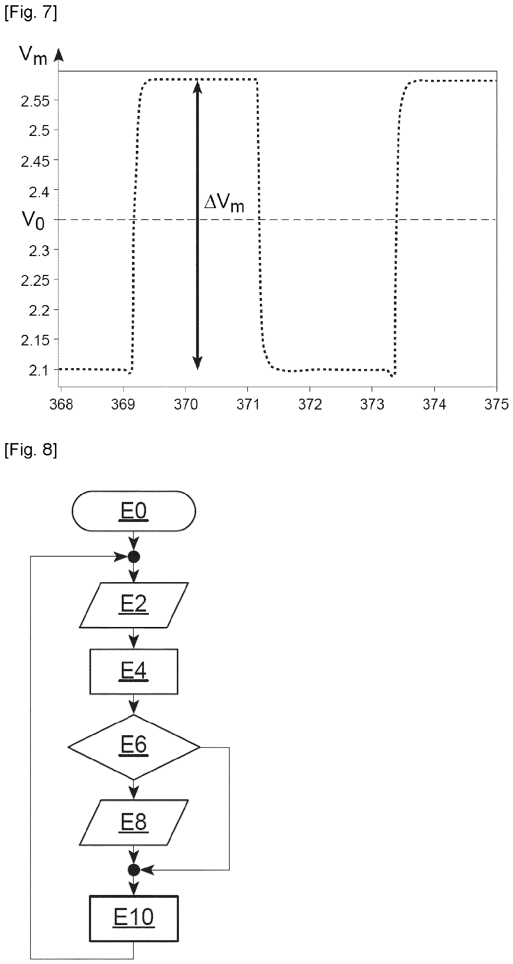

Sur la figure 7, on a représenté l'allure de la modélisation du signal de tension $V_m$ lorsque l'une ou l'autre des situations à risque précitées intervient. Dans ces situations à risque, ce signal augmente en effet rapidement puis rechute brusquement ensuite.

Pour caractériser les perturbations à l'origine d'une fausse détection de défaut d'isolation électrique, la présente invention propose de se baser sur au moins deux paramètres.

Ici, de façon préférentielle, le contrôle de la validité d'une détection d'un défaut d'isolation se base sur l'exploitation d'exactement deux paramètres.

Ici, ces deux paramètres sont :

- l'écart de tension $V_m$ mesurée entre les deux périodes $T_1$, $T_2$, noté $\Delta V_m$, et
- la moyenne de la tension $V_m$ mesurée entre les deux périodes $T_1$, $T_2$, notée $V_0$.

Ces deux paramètres sont calculés au moyen des équations suivantes :

[Math. 5]

$$\Delta V_m = V_{m2} - V_{m1}$$

[Math. 6]

$$V_0 = \frac{(V_{m2} + V_{m1})}{2}$$

Chaque perturbation génère une variation brusque de ces deux paramètres. En surveillant, au cours de la seconde phase de ce procédé, l'évolution dans le temps de ces paramètres, il est ainsi possible de contrôler la fiabilité de la détection du défaut d'isolation réalisée au cours de la première phase.

A ce stade, on peut noter que ces deux paramètres sont directement liés à la valeur $R_i$ de la résistance d'isolation 66 et du coefficient $\alpha$, selon les équations suivantes :

[Math. 7]

$$\Delta V_m = \frac{R_m}{R_i + R_d + R_m} \, \Delta V_d$$

[Math. 8]

$$\alpha = \beta V_0 + \gamma$$

Dans ces équations, les variables $\beta$ et $\gamma$ sont définies ainsi :

[Math. 9]

$$\beta = \frac{2 \, \Delta U_d}{U_{bat} \, \Delta V_m}$$

[Math. 10]

$$\gamma = \frac{U_{m2}U_{d2} - U_{m1}U_{d1}}{U_{bat}\,\Delta V_m}$$

On peut maintenant décrire, en référence à la figure 8, comment la seconde phase est mise en oeuvre, après son initialisation à l'étape E0.

Lors d'une première étape E2, le calculateur 50 acquiert les deux valeurs $Vm_1$, $Vm_2$ de tension précédemment mesurées. Il acquiert également les valeurs (notées $\Delta V_{m,t-1}$, $V_{0,\,t-1}$) des deux paramètres $\Delta V_m$, $V_0$ calculés au pas de temps précédent.

Puis, lors d'une seconde étape E4, le calculateur calcule les valeurs instantanées (notées $\Delta V_{m,t}$, Va,t) des deux paramètres $\Delta V_m$, Va.

Au cours d'une troisième étape E6, le calculateur 50 observe les variations dans le temps des deux paramètres afin de détecter s'il se trouve dans une situation à risque de fausse détection de défaut d'isolation électrique.

Pour cela, il compare ici respectivement les variations de chacun des deux paramètres entre les deux pas de temps avec deux seuils S1, S2. En d'autres termes, il vérifie si les deux inégalités suivantes sont vérifiées :

[Math. 11]

$$\left|\Delta V_{m,t} - \Delta V_{m,t-1}\right| \leq S1$$

[Math. 12]

$$\left|V_{0,t} - V_{0,t-1}\right| \leq S2$$

Le calculateur 50 déduit alors du résultat de ces deux inéquations le niveau de fiabilité de la valeur $R_i$ de résistance d'isolation obtenu lors de la première phase du procédé. Ce niveau de fiabilité est ici de type booléen et peut prendre deux états : « fiable » et « pas fiable ».

En pratique, le calculateur 50 peut être programmé de différentes manières pour exploiter les deux inéquations précitées.

Dans un premier mode de réalisation, il est programmé pour vérifier si l'une ou moins de ces deux inégalités est fausse.

Si tel est le cas, le calculateur 50 considère que le résultat de la première phase n'est pas fiable. Par conséquent, aucune opération n'est entreprise sur la base de la valeur $R_i$ de résistance d'isolation 66.

Dans le cas contraire, le résultat de la première phase est jugé fiable. Il est donc exploité au cours d'une étape E8. Pour cela, le calculateur mémorise la valeur $R_i$ de la résistance d'isolation 66 et du coefficient $\alpha$, et ces données sont ensuite exploitées pour commander par exemple l'ouverture du ou des interrupteurs 33, 34.

Le procédé s'achève ensuite au cours de l'étape E10.

Dans un second mode de réalisation, le calculateur 50 est programmé pour vérifier si ces deux inégalités sont simultanément fausses. Si tel est le cas, il considère que le résultat de la première phase n'est pas fiable. Dans le cas contraire, le résultat de la première phase est jugé fiable.

La présente invention n'est nullement limitée aux modes de réalisation décrits et représentés, mais l'homme du métier saura y apporter toute variante conforme aux revendications jointes.

Par exemple, la seconde phase pourrait être mise en oeuvre avant la première phase, et la mise en oeuvre de la première phase pourrait être conditionnée au résultat de la seconde phase.

En d'autres termes, il est possible, avant de calculer la valeur $R_i$ de la résistance d'isolation 66 et du coefficient $\alpha$, de déterminer si on se trouve ou non dans une situation à risque de fausse détection. Pour cela, le calculateur contrôle si l'une ou les deux inégalités précitées sont vérifiées. Puis, si on se trouve dans une situation à risque, aucune autre action n'est entreprise. Dans le cas contraire, le calculateur 50 calcule la valeur $R_i$ de la résistance d'isolation 66 et du coefficient $\alpha$ puis il exploite directement ces données.

Selon une variante de réalisation ne faisant pas partie de l'objet revendiqué, les deux paramètres utilisés pourraient être différents de ceux utilisés dans le mode de réalisation décrit. Dans le mode décrit, les deux paramètres $\Delta V_m$, $V_0$ sont des caractéristiques du signal de la tension $V_m$ mesurée. En variante, ces deux paramètres pourraient être de simples fonctions des valeurs de la tension $V_m$ mesurée. A titre d'exemple, ces deux paramètres pourraient être formés par la valeur $R_i$ de la résistance d'isolation 66 et par celle du coefficient $\alpha$.

Selon encore une autre variante de l'invention, les deux inéquations précitées pourraient être basées sur les variations des deux paramètres non pas entre deux pas de temps successifs, mais entre un plus grand nombre de pas de temps.

Selon encore une autre variante de l'invention, les deux inéquations précitées pourraient être basées non pas sur les variations des deux paramètres dans le temps, mais sur les valeurs de ces deux paramètres.

**Revendications**

1. Procédé de détection d'un défaut d'isolation électrique entre une source d'énergie électrique (20) et une masse électrique (30), au moyen d'un circuit (40) qui comporte un générateur de tension (41) pilotable et une résistance électrique de mesure (43) branchés en série entre une borne de la source d'énergie électrique (20) et la masse électrique (30), et qui comprend également un moyen de mesure (45) de la tension ($V_m$) aux bornes de la résistance électrique de mesure, ledit procédé comportant des étapes de :

   - pilotage du générateur de tension (41) de manière qu'il établisse entre ses bornes une tension ($V_d$) de valeur non nulle, et de
   - mesure de la tension ($V_m$) aux bornes de la résistance électrique de mesure (43) pour détecter un défaut d'isolation électrique entre la source d'énergie électrique (20) et la masse électrique (30),

   **caractérisé en ce que** :

   à l'étape de pilotage, le générateur de tension (41) est piloté de manière que la tension ($V_d$) prenne pendant deux périodes ($T_1$, $T_2$) successives deux valeurs ($V_{d1}$, $V_{d2}$) non nulles et différentes l'une de l'autre,
   à l'étape de mesure, deux valeurs ($V_{m1}$, $V_{m2}$) de la tension ($V_m$) aux bornes de la résistance électrique de mesure (43) sont respectivement mesurées pendant les deux périodes ($T_1$, $T_2$), et
   **en ce que** le procédé comporte en outre une étape de contrôle au cours de laquelle un calculateur :

   - détermine, en fonction au moins des valeurs ($V_{m1}$, $V_{m2}$) de la tension ($V_m$) mesurées aux bornes de la résistance électrique de mesure (43), au moins deux paramètres ($\Delta V_m$, $V_0$) caractéristiques d'une perturbation affectant la détection du défaut d'isolation électrique, l'un des paramètres ($V_0$) étant une fonction de la moyenne arithmétique entre les deux valeurs ($V_{m1}$, $V_{m2}$) mesurées de la tension ($V_m$) aux bornes de la résistance électrique de mesure (43), et/ou une fonction de l'écart ($\Delta V_m$) entre les deux valeurs ($V_{m1}$, $V_{m2}$) mesurées de la tension ($V_m$) aux bornes de la résistance électrique de mesure (43),
   - calcule un niveau de fiabilité de la détection du défaut d'isolation électrique en fonction de l'un au moins des deux paramètres ($\Delta V_m$, $V_0$).

2. Procédé de détection selon la revendication 1, dans lequel il est prévu, entre l'étape de mesure et l'étape de contrôle, une étape de détection du défaut d'isolation électrique et dans lequel le résultat de ladite étape de détection est exploité ou non en fonction du niveau de fiabilité calculé.

3. Procédé de détection selon la revendication 1, dans lequel il est prévu, après l'étape de contrôle, une étape de détection du défaut d'isolation électrique uniquement si le niveau de fiabilité indique que la détection du défaut d'isolation électrique sera fiable.

4. Procédé de détection selon l'une des revendications précédentes, dans lequel, pour détecter un défaut d'isolation électrique, le calculateur calcule la valeur ($R_i$) d'une résistance d'isolation (66) de ladite source d'énergie électrique (20) par rapport à la masse électrique (30) puis compare ladite valeur ($R_i$) avec un seuil.

5. Procédé de détection selon l'une des revendications précédentes, dans lequel, si un défaut d'isolation électrique est détecté, le calculateur calcule un coefficient (a) de positionnement du défaut d'isolation électrique au sein de ladite source d'énergie électrique (20).

6. Procédé de détection selon l'une des revendications précédentes, dans lequel, à l'étape de contrôle, le calcul du niveau de fiabilité est réalisé en fonction des deux paramètres ($\Delta V_m$, $V_0$).

7. Procédé de détection selon l'une des revendications précédentes, dans lequel, à l'étape de contrôle, le calcul du niveau de fiabilité est réalisé en fonction de la variation dans le temps de l'un au moins des deux paramètres ($\Delta V_m$, $V_0$).

8. Dispositif de détection d'un défaut d'isolation électrique entre une source d'énergie électrique (20) et une masse électrique (30), comportant :

- un circuit (40) qui comporte un générateur de tension (41) pilotable et une résistance électrique de mesure (43) branchés en série entre une borne de la source d'énergie électrique (20) et la masse électrique (30), et qui comprend un moyen de mesure (45) de l'intensité du courant ($i_d$) circulant au travers de la résistance électrique de mesure (43), et
- un calculateur adapté à mettre en oeuvre un procédé de détection conforme à l'une des revendications précédentes.

9. Véhicule automobile comportant une source d'énergie électrique (20) et une masse électrique (30), **caractérisé en ce qu'**il comporte un dispositif de détection conforme à la revendication précédente.

**Patentansprüche**

1. Verfahren zur Erkennung eines elektrischen Isolationsfehlers zwischen einer elektrischen Energiequelle (20) und einer elektrischen Masse (30) mittels einer Schaltung (40), die einen ansteuerbaren Spannungsgenerator (41) und einen elektrischen Messwiderstand (43) umfasst, die in Reihe zwischen einer Klemme der elektrischen Energiequelle (20) und der elektrischen Masse (30) angeschlossen sind, und die auch ein Messmittel (45) zum Messen der Spannung ($V_m$) an den Klemmen des elektrischen Messwiderstands aufweist, wobei das Verfahren die folgenden Schritte umfasst:

- Ansteuern des Spannungsgenerators (41), so dass er zwischen seinen Klemmen eine Spannung ($V_d$) mit einem Wert ungleich null aufbaut, und
- Messen der Spannung ($V_m$) an den Klemmen des elektrischen Messwiderstands (43), um einen elektrischen Isolationsfehler zwischen der elektrischen Energiequelle (20) und der elektrischen Masse (30) zu erkennen, **dadurch gekennzeichnet, dass**:

bei dem Schritt des Ansteuerns der Spannungsgenerator (41) so angesteuert wird, dass die Spannung ($V_d$) während zwei aufeinanderfolgender Perioden ($T_1$, $T_2$) zwei Werte ($V_{d1}$, $V_{d2}$) annimmt, die ungleich null und voneinander verschieden sind,
bei dem Schritt des Messens zwei Werte ($V_{m1}$, $V_{m2}$) der Spannung ($V_m$) an den Klemmen des elektrischen Messwiderstands (43) jeweils während der beiden Perioden ($T_1$, $T_2$) gemessen werden, und
dadurch, dass das Verfahren ferner einen Schritt des Kontrollierens umfasst, in dessen Verlauf ein Rechner:

- in Abhängigkeit mindestens von den Werten ($V_{m1}$, $V_{m2}$) der Spannung ($V_m$), die an den Klemmen des elektrischen Messwiderstands (43) gemessen werden, mindestens zwei Parameter ($\Delta V_m$, $V_0$) bestimmt, die charakteristisch für eine Störung sind, die die Erkennung des elektrischen Isolationsfehlers beeinflusst, wobei der eine der Parameter ($V_0$) eine Funktion des arithmetischen Mittelwerts zwischen den beiden gemessen Werten ($V_{m1}$, $V_{m2}$) der Spannung ($V_m$) an den Klemmen des elektrischen Messwiderstands (43) und/oder eine Funktion der Differenz ($\Delta V_m$) zwischen den beiden gemessenen Werten ($V_{m1}$, $V_{m2}$) der Spannung ($V_m$) an den Klemmen des elektrischen Messwiderstands (43) ist,
- ein Zuverlässigkeitsniveau der Erkennung des elektrischen Isolationsfehlers in Abhängigkeit von mindestens dem einen der beiden Parameter ($\Delta V_m$, $V_0$) berechnet.

2. Verfahren zur Erkennung nach Anspruch 1, bei dem zwischen dem Schritt des Messens und dem Schritt des Kontrollierens ein Schritt des Erkennens des elektrischen Isolationsfehlers vorgesehen ist und bei dem das Ergebnis des Schritts des Erkennens in Abhängigkeit von dem berechneten Zuverlässigkeitsniveau ausgewertet wird oder nicht.

3. Verfahren zur Erkennung nach Anspruch 1, bei dem nach dem Schritt des Kontrollierens ein Schritt des Erkennens des elektrischen Isolationsfehles nur vorgesehen ist, wenn das Zuverlässigkeitsniveau angibt, dass die Erkennung des elektrischen Isolationsfehlers zuverlässig ist.

4. Verfahren zur Erkennung nach einem der vorhergehenden Ansprüche, bei dem der Rechner, zum Erkennen eines elektrischen Isolationsfehlers, den Wert ($R_i$) eines Isolationswiderstands (66) der elektrischen Energiequelle (20) bezogen auf die elektrische Masse (30) berechnet, dann den Wert ($R_i$) mit einem Schwellenwert vergleicht.

**5.** Verfahren zur Erkennung nach einem der vorhergehenden Ansprüche, bei dem der Rechner, wenn ein elektrischer Isolationsfehler erkannt wird, einen Positionierungskoeffizienten ($\alpha$) des elektrischen Isolationsfehlers in der elektrischen Energiequelle (20) berechnet.

**6.** Verfahren zur Erkennung nach einem der vorhergehenden Ansprüche, bei dem, bei dem Schritt des Kontrollieren, das Berechnen des Zuverlässigkeitsniveaus in Abhängigkeit von den beiden Parametern ($\Delta V_m$, $V_0$) ausgeführt wird.

**7.** Verfahren zur Erkennung nach einem der vorhergehenden Ansprüche, bei dem, bei dem Schritt des Kontrollierens, das Berechnen des Zuverlässigkeitsniveaus in Abhängigkeit von der zeitlichen Änderung mindestens des einen der beiden Parameter ($\Delta V_m$, $V_0$) ausgeführt wird.

**8.** Vorrichtung zur Erkennung eines elektrischen Isolationsfehlers zwischen einer elektrischen Energiequelle (20) und einer elektrischen Masse (30), umfassend:

- eine Schaltung (40), die einen ansteuerbaren Spannungsgenerator (41) und einen elektrischen Messwiderstand (43) umfasst, die in Reihe zwischen einer Klemme der elektrischen Energiequelle (20) und der elektrischen Masse (30) angeschlossen sind, und die ein Messmittel (45) zum Messen der Stärke des Stroms ($i_d$) aufweist, der durch den elektrischen Messwiderstand (43) fließt, und
- einen Rechner, der geeignet ist, ein Verfahren zur Erkennung nach einem der vorhergehenden Ansprüche durchzuführen.

**9.** Kraftfahrzeug, umfassend eine elektrische Energiequelle (20) und eine elektrische Masse (30), **dadurch gekennzeichnet, dass** es eine Vorrichtung zur Erkennung nach dem vorhergehenden Anspruch umfasst.

**Claims**

**1.** Method for detecting an electrical insulation fault between an electrical power source (20) and an electrical ground (30), by means of a circuit (40) which comprises a controllable voltage generator (41) and an electrical measurement resistor (43) connected in series between a terminal of the electrical power source (20) and the electrical ground (30), and which also comprises a means (45) for measuring the voltage ($V_m$) at the terminals of the electrical measurement resistor, said method comprising steps of:

- controlling the voltage generator (41) in such a way that it establishes, between its terminals, a voltage ($V_d$) of non-zero value, and of
- measuring the voltage ($V_m$) at the terminals of the electrical measurement resistor (43) to detect an electrical insulation fault between the electrical power source (20) and the electrical ground (30), **characterized in that**:

in the control step, the voltage generator (41) is controlled in such a way that the voltage (Vd) takes, during two successive periods ($T_1$, $T_2$), two non-zero and mutually different values ($V_{d1}$, $V_{d2}$),
in the measurement step, two values ($V_{m1}$, $V_{m2}$) of the voltage ($V_m$) at the terminals of the electrical measurement resistor (43) are respectively measured during the two periods ($T_1$, $T_2$), and
**in that** the method further comprises a checking step during which a computer:

- determines, as a function at least of the values ($V_{m1}$, $V_{m2}$) of the voltage ($V_m$) measured at the terminals of the electrical measurement resistor (43), at least two parameters ($\Delta V_m$, $V_0$) characteristic of a disturbance affecting the detection of the electrical insulation fault, one of the parameters ($V_0$) being a function of the arithmetic mean between the two measured values ($V_{m1}$, $V_{m2}$) of the voltage ($V_m$) at the terminals of the electrical measurement resistor (43), and/or a function of the deviation ($\Delta V_m$) between the two measured values ($V_{m1}$, $V_{m2}$) of the voltage ($V_m$) at the terminals of the electrical measurement resistor (43),
- calculates a level of reliability of the detection of the electrical insulation fault as a function of at least one of the two parameters ($\Delta V_m$, $V_0$).

**2.** Detection method according to Claim 1, wherein, between the measurement step and the checking step, a step of detection of the electrical insulation fault is provided and wherein the result of said detection step is used or not depending on the calculated level of reliability.

3. Detection method according to Claim 1, wherein, after the checking step, a step of detection of the electrical insulation fault is provided only if the level of reliability indicates that the detection of the electrical insulation fault will be reliable.

4. Detection method according to one of the preceding claims, wherein, to detect an electrical insulation fault, the computer calculates the value ($R_i$) of an insulation resistance (66) of said electrical power source (20) with respect to the electrical ground (30) then compares said value ($R_i$) with a threshold.

5. Detection method according to one of the preceding claims, wherein, if an electrical insulation fault is detected, the computer calculates a coefficient (a) of positioning of the electrical insulation fault within said electrical power source (20).

6. Detection method according to one of the preceding claims, wherein, in the checking step, the calculation of the level of reliability is done as a function of the two parameters ($\Delta V_m$, $V_0$).

7. Detection method according to one of the preceding claims, wherein, in the checking step, the calculation of the level of reliability is done as a function of the variation in time of at least one of the two parameters ($\Delta V_m$, $V_0$) .

8. Device for detecting an electrical insulation fault between an electrical power source (20) and an electrical ground (30), comprising:

    - a circuit (40) which comprises a controllable voltage generator (41) and an electrical measurement resistor (43) connected in series between a terminal of the electrical power source (20) and the electrical ground (30), and which comprises a means (45) for measuring the intensity of the current ($i_d$) circulating through the electrical measurement resistor (43), and
    - a computer suitable for implementing a detection method conforming to one of the preceding claims.

9. Motor vehicle comprising an electrical power source (20) and an electrical ground (30), **characterized in that** it comprises a detection device conforming to the preceding claim.

[Fig. 1]

[Fig. 2]

[Fig. 3]

[Fig. 4]

[Fig. 5]

[Fig. 6]

[Fig. 7]

[Fig. 8]

## RÉFÉRENCES CITÉES DANS LA DESCRIPTION

**Documents brevets cités dans la description**

- EP 0654673 A
- FR 3037406 A1

- US 2017106754 A1